# EUROPEAN PATENT APPLICATION

(11) **EP 4 568 029 A1**
(43) Date of publication of application: **11.06.2025**
(21) Application number: 23849130.2
(22) Date of filing: 30.06.2023
(51) Int. Cl.: H01S 3/094

(54) **PUMPING SYSTEM FOR USE IN VEHICLE-MOUNTED LASER, VEHICLE-MOUNTED LASER DEVICE, AND VEHICLE**

(30) Priority: 03.08.2022 CN 202210927480
(71) Applicant: Nio Co., Ltd., Shanghai 201804 (CN); Nio Technology (Anhui) Co., Ltd, Hefei City, Anhui 230601 (CN)
(72) Inventor: DENG, Yongzhang, Hefei, Anhui 230601 (CN)
(74) Representative: Vossius & Partner Patentanwälte Rechtsanwälte mbB
(86) International application number: PCT/CN2023/104871
(87) International publication number: WO 2024/027420

(57) **Abstract**

The disclosure relates to the field of vehicle-mounted lasers, and in particular, to a pumping system for use in a vehicle-mounted laser, a vehicle-mounted laser device, and a vehicle. The pumping system includes: a pump source module including at least a first pump source and a second pump source, where the second pump source serves as a backup pump source for the first pump source; and a control circuit including: a current measurement circuit configured to measure a real-time operating current of the first pump source; and a comparison circuit configured to determine an operating state of the first pump source based on the real-time operating current, and to switch on the second pump source when the first pump source is in an abnormal state, so as to provide pump light.

## Description

### Technical Field

The disclosure relates to the field of vehicle-mounted lasers, and in particular, to a pumping system for use in a vehicle-mounted laser, a vehicle-mounted laser device, and a vehicle.

### Background Art

Lasers were mainly used in the industrial field in early days, and accordingly the requirements for the real-time performance and reliability of laser products were relatively loose. With the rise of autonomous driving technology, lasers such as laser radars are increasingly used in the automotive field, thus putting forward higher requirements for the real-time performance and reliability of laser products and in particular their pump sources. At present, there is a lack of real-time control solutions for pump sources and associated designs for how to apply the pump sources to vehicle-mounted laser radars in the art.

### Summary

Embodiments of the disclosure provide a pumping system for use in a vehicle-mounted laser, a vehicle-mounted laser device, and a vehicle, so as to meet the high requirements for the reliability and real-time performance of the vehicle-mounted laser for pump sources.

According to a first aspect of the disclosure, there is provided a pumping system for use in a vehicle-mounted laser. The pumping system includes: a pump source module including at least a first pump source and a second pump source, where the second pump source serves as a backup pump source for the first pump source; and a control circuit including: a current measurement circuit configured to measure a real-time operating current of the first pump source; and a comparison circuit configured to determine an operating state of the first pump source based on the real-time operating current, and to switch on the second pump source when the first pump source is in an abnormal state, so as to provide pump light.

As an alternative or addition to the above solution, the pumping system according to an embodiment of the disclosure further includes a pump drive module configured to provide a drive current to the pump source module under the control of the control circuit.

As an alternative or addition to the above solution, in the pumping system according to an embodiment of the disclosure, the current measurement circuit includes: a sampling resistor coupled between the pump drive module and the first pump source; and a differential amplifier, a non-inverting input end and an inverting input end of the differential amplifier being connected to two ends of the sampling resistor respectively, and an output end of the differential amplifier being connected to the comparison circuit.

As an alternative or addition to the above solution, in the pumping system according to an embodiment of the disclosure, the comparison circuit includes: a comparator, a non-inverting input end of the comparator being connected to an output end of the current measurement circuit, and an inverting input end of the comparator being connected to a reference voltage; and a first transistor, the first transistor being turned on when the comparator outputs a low level, so as to provide a drive current to the second pump source.

As an alternative or addition to the above solution, in the pumping system according to an embodiment of the disclosure, the first transistor is a PMOS transistor, where a gate of the first transistor is connected to an output end of the comparator, a drain of the first transistor is connected to the second pump source, and a source of the first transistor is connected to a pump drive module.

As an alternative or addition to the above solution, in the pumping system according to an embodiment of the disclosure, the comparison circuit further includes a second transistor, the second transistor being turned off when the comparator outputs a low level, so as to switch off the first pump source.

As an alternative or addition to the above solution, in the pumping system according to an embodiment of the disclosure, the comparison circuit further includes an inverter having an input end connected to an output end of the comparator, and the second transistor is a PMOS transistor, where a gate of the second transistor is connected to an output end of the inverter, a drain of the second transistor is connected to the first pump source, and a source of the second transistor is connected to a pump drive module.

As an alternative or addition to the above solution, the pumping system according to an embodiment of the disclosure further includes: an alarm module configured to generate a prompt signal when the first pump source is in an abnormal state.

As an alternative or addition to the above solution, in the pumping system according to an embodiment of the disclosure, the alarm circuit has an input end connected to a drain of a first transistor of the comparison circuit, and is activated and generates the prompt signal when the first transistor is turned on.

According to a second aspect of the disclosure, there is provided a vehicle-mounted laser device, including: any one of the pumping systems according to the first aspect of the disclosure; a seed source configured to provide seed light; and an optical amplifier configured to receive the seed light from the seed source and pump light from the pumping system to generate a laser beam.

According to a third aspect of the disclosure, there is provided a vehicle, including any one of the vehicle-mounted laser devices according to the second aspect of the disclosure.

Firstly, a pumping system for use in a vehicle-mounted laser according to one or more embodiments of the disclosure uses a redundant design solution for pump sources. For example, when a primary pump source fails, a backup pump source can be switched on in a timely manner to provide pump light, thus greatly reducing the failure rate of a pump source module and improving the reliability of the pump source module.

Secondly, the pumping system for use in a vehicle-mounted laser according to one or more embodiments of the disclosure uses pure hardware means (i.e., a hardware control circuit including a current measurement circuit and a comparison circuit) to monitor an operating current of a pump source; and compared to a software control solution, a pure hardware circuit has the advantages of a simpler structure, a lower failure rate, and a shorter control time, thus further reducing the downtime of the pump source module, improving the reliability of the pump source module, and creating conditions for the use of the pump sources in vehicles and in particular in the field of autonomous driving (e.g., a vehicle-mounted laser radar).

### Brief Description of the Drawings

The above and other objectives and advantages of the disclosure will be more thorough and clearer from the following detailed description in conjunction with the accompanying drawings, in which the same or similar elements are denoted by the same reference numerals.
FIG. 1 shows a schematic block diagram of a pumping system 10 for use in a vehicle-mounted laser according to an embodiment of the disclosure;
FIG. 2 shows a schematic structure diagram of a pumping system 20 for use in a vehicle-mounted laser according to an embodiment of the disclosure; and
FIG. 3 shows a schematic block diagram of a vehicle-mounted laser device 30 according to an embodiment of the disclosure.

### Detailed Description of Embodiments

The following descriptions of the specific embodiments are merely exemplary in nature, and are not intended to limit the disclosed technologies or the application and use of the disclosed technologies. In addition, there is no intention to be bound by any expressed or implied theory presented in the foregoing Technical Field and Background Art, or the following Detailed Description.

The terms such as "include" and "comprise" are used to indicate that in addition to units and steps that are directly and clearly described in this specification, other units and steps that are not directly or clearly described are not excluded in the technical solutions of the disclosure. The terms such as "first" and "second" are not used to indicate sequences of the units in terms of time, space, size, etc., and are merely used to distinguish between the units.

It is to be understood that the technologies in the disclosure are commonly used in electric vehicles, including, but not limited to, battery electric vehicles (BEVs), hybrid electric vehicles (HEVs), fuel cell electric vehicles (FCEVs), etc.

Various exemplary embodiments according to the disclosure will be described below in detail with reference to the accompanying drawings.

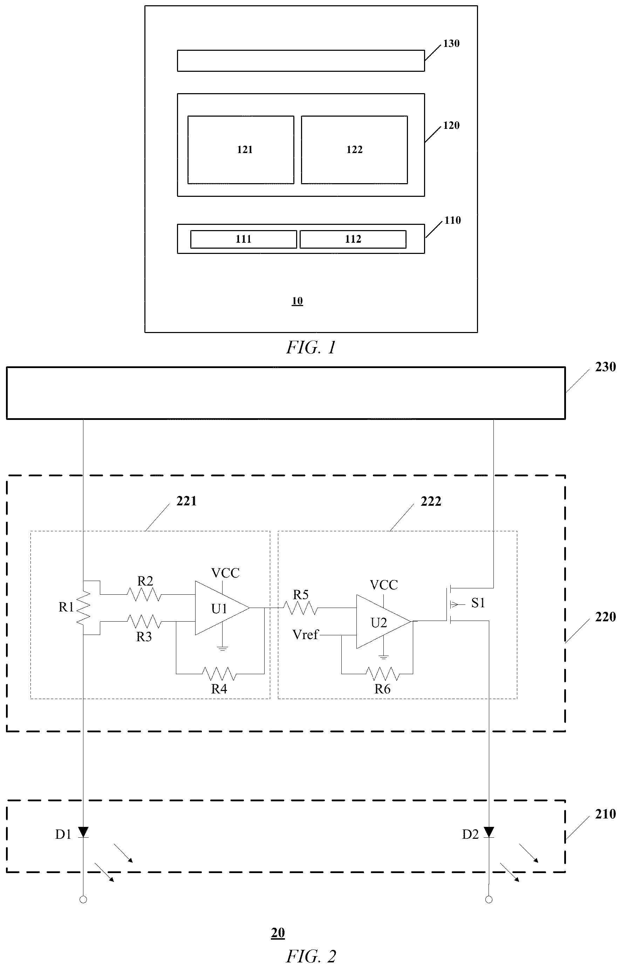

In a first aspect, the disclosure provides a pumping system for use in a vehicle-mounted laser. As shown in FIG. 1, the pumping system 10 includes a pump source module 110 and a control circuit 120. Optionally, the pumping system 10 may further include a pump drive module 130 and/or an alarm circuit 140. The pumping system 10 is used for providing energy (i.e., pump light) to an optical amplifier of the vehicle-mounted laser to achieve amplification of seed light emitted by a seed source.

The pumping system 10 according to the disclosure uses a redundant design structure for pump sources. That is, the pump source module 110 includes at least two pump sources, for example, a first pump source 111 and a second pump source 112, where the first pump source 111 serves as a primary pump source and the second pump source 112 serves as a backup pump source for the first pump source 111. It should be understood that the pump source module 110 may further include more redundant pump sources such as a third pump source, for example, as a backup pump source for the second pump source 112. Depending on the specific amplification requirements of the vehicle-mounted laser for a seed light signal, each pump source of the pump source module 110 may be a single-stage pump source or a multi-stage pump source.

The pump drive module 130 is configured to provide a drive current to the pump source module 110 under the control of the control circuit 120. The pump drive module 130 may have a plurality of current output ports each electrically coupled directly or indirectly (e.g., via the control circuit 120) to a corresponding pump source (e.g., the first pump source 111 and the second pump source 112) of the pump source module 110.

By way of example, the pump source module 110 and the control circuit 120 of the disclosure operate at a direct-current (DC) voltage. Therefore, the voltage and current mentioned in the context of the disclosure refers to the DC voltage and current. Specifically, in some examples, for example, the positive polarity of an input voltage provided by the pump drive module 130 may be introduced directly or indirectly into the control circuit 120, and the negative polarity may be introduced to the circuit by means of conventional connection in the art. In other examples, depending on the types of components of the circuit or the requirements of circuit design, it is also possible to operate for the negative polarity of the input voltage, and the scope of protection of the disclosure extends to such variants.

The control circuit 120 of the pumping system 10 is partially coupled between the pump drive module 130 and the pump source module 110, to determine whether the pump source (e.g., the first pump source 111) in an operating state is in a normal operating state by monitoring an operating current of the pump source in real time, and accordingly to realize the switch-on or switching of the backup pump source.

Specifically, the control circuit 120 includes a current measurement circuit 121 and a comparison circuit 122. The current measurement circuit 121 is configured to measure a real-time operating current of the first pump source 111 in an operating state. In one example, the current measurement circuit 121 includes a sampling resistor coupled between the pump drive module 130 and the first pump source 111, and an operational amplifier (e.g., a differential amplifier). The current measurement circuit 121 samples the operating current of the first pump source 111 by measuring a voltage value across the sampling resistor. In a practical operation, a resistance value of the sampling resistor may be set based on an amplification factor of the operational amplifier and a measurement target range (i.e., a range of the real-time operating current of the first pump source 111). The current measurement circuit 121 transmits the sampled operating current to the operational amplifier to realize amplification of the measured voltage value by means of the operational amplifier (e.g., to realize proportional amplification of the measured voltage value by means of the differential amplifier) so as to facilitate the operation of the comparison circuit.

The comparison circuit 122 is configured to determine the operating state of the first pump source 111 based on the real-time operating current measured by the current measurement circuit 121. If the first pump source 111 is in an abnormal state, the comparison circuit 122 will switch on the second pump source 112 to provide pump light; and if the first pump source 111 is in a normal state, the comparison circuit 122 continue maintaining the off state of the second pump source 112 and the on state of the first pump source 111. Optionally, when the first pump source 111 is in an abnormal state, the comparison circuit 122 may also switch off the first pump source 111. Optionally, when the first pump source 111 is in an abnormal state, the comparison circuit 122 may further switch on the alarm circuit 140 to generate a prompt signal.

In one example, the comparison circuit 122 includes a comparator and one or more transistors. The comparator determines the operating state of the first pump source 111 based on a comparison result between the measured voltage value and a preset reference voltage. In a practical operation, the value of the reference voltage may be set in a targeted manner according to the most common types of failure of the first pump source 111 (e.g., open circuit or device short circuit). For example, when a certain type of failure occurs in the first pump source 111, the operating current of the first pump source may be embodied as a typical value indicating this type of failure, and then a corresponding reference voltage may be set so as to accurately identify that typical value, thereby determining that the first pump source 111 has that type of failure. In other examples, it is also possible to set a plurality of reference voltages according to various possible types of failure of the first pump source 111. Compared to the use of an ADC conversion solution (e.g., by converting the real-time operating current and analyzing specific characteristics of the converted signal), such a solution in which the operating state of the first pump source 111 is determined by means of voltage comparison can minimize the complexity of the solution and can reduce the costs for implementation. Further, the comparison circuit 122 uses one or more transistors to realize one or more of the functions of switching on the second pump source 112, switching off the first pump source 111, and switching on the alarm circuit 140. The one or more transistors for realizing the above functions do not necessarily have the same model or type. For example, the switch-on of the second pump source 112 and the switch-on of the alarm circuit 140 may be realized by means of a first transistor, and the switch-off of the first pump source 111 may be realized by means of a second transistor. The disclosure does not limit the specific types and models of the transistors herein, as long as they can realize the functions described in the context of the disclosure.

As can be seen from the description in the context of the disclosure, the transistor in the disclosure refers to a transistor that may be controlled to operate, such as a field-effect transistor and a triode. In some examples, the transistor may be a P-channel MOS transistor (PMOS transistor), an N-channel MOS transistor (NMOS transistor), a PNP-type triode, or an NPN-type triode, etc. Depending on the on and off characteristics of the transistor, the respective pump sources such as the first pump source 111 and the second pump source 112, for example, may realize switching between the on or off state based on a change in the real-time operating current (which is equivalent to the measured voltage value) measured by the current measurement circuit 121.

The pumping system 10 shown in FIG. 1 uses a redundant design solution for the pump sources and uses pure hardware means (i.e., the pump source module 110, the control circuit 120, the pump drive module 130, and the alarm circuit 140) to monitor the operating current of the pump source; and compared to a software control solution, a pure hardware circuit has the advantages of a simpler structure, a lower failure rate, and a shorter control time, thus reducing the downtime of the pump source module, improving the reliability of the pump source module, and creating conditions for the use of the pump sources in vehicles and in particular in the field of autonomous driving (e.g., a vehicle-mounted laser radar).

Referring further to FIG. 2 below, FIG. 2 shows a schematic structure diagram of a pumping system 20 for use in a vehicle-mounted laser according to an embodiment of the disclosure. Corresponding to the pumping system 10 shown in FIG. 1, the pumping system 20 as shown in FIG. 2 includes a pump source module 210, a control circuit 220, and a pump drive module 230.

The pump source module 210 includes two pump sources, i.e., a first pump source as a primary pump source and a second pump source as a backup pump source. By way of example, the pump sources may be semiconductor lasers, such as diode pumps. In the embodiment shown in FIG. 2, the pump sources are shown as diode pumps, i.e., a first pump source D1 and a second pump source D2. It should be understood that the pump source module 210 may further include more redundant pump sources such as a third pump source D3. Such a redundant design solution for the pump sources can significantly reduce the failure rate of the pump source module and also improve the reliability of the pump source module.

The pump drive module 230 provides a drive current to the pump source module 210 under the control of the control circuit 220. In this embodiment, the pump drive module 230 has two current output ports, the current output ports are indirectly electrically coupled to the first pump source D1 and the second pump source D2 respectively via the control circuit 220.

The control circuit 220 includes a current measurement circuit 221 and a comparison circuit 222 that correspond to the current measurement circuit 121 and the comparison circuit 122 respectively as shown in FIG. 1, to determine whether the first pump source D1 in an operating state is in a normal operating state by monitoring an operating current of the first pump source in real time, and accordingly to realize the switch-on or switching of the second pump source D2.

Specifically, the current measurement circuit 121 includes a first resistor R1 (i.e., the sampling resistor) coupled between the pump drive module 230 and the first pump source D1, and a differential amplifier U1. A non-inverting input end of the differential amplifier U1 is connected to one end of the first resistor R1 via a second resistor R2, an inverting input end thereof is connected to the other end of the first resistor R1 via a third resistor R3 and is connected to an output end of the differential amplifier U1 via a fourth resistor R4, and the output end of the differential amplifier U1 is connected to the comparison circuit 222. The differential amplifier U1 proportionally amplifies the measured voltage value of the first resistor R1 (which is equivalent to the operating current of the first pump source D1 according to Ohm's law) and inputs the amplified voltage value to the comparison circuit 222.

In this embodiment, the comparison circuit 222 includes a comparator U2 and a first transistor S1. The comparator U2 determines the operating state of the first pump source D1 based on a comparison result between the amplified voltage value and a preset reference voltage. Specifically, the differential amplifier U1 inputs the amplified voltage value to a non-inverting input end of the comparator U2 via a fifth resistor R5, an inverting input end of the comparator U2 is connected to the reference voltage, and an output end of the comparator U2 is connected to the first transistor S1. By way of example, the above reference voltage Vref is set as a critical value for determining whether the first pump source D1 has a certain type of failure. In FIG. 2, the first transistor S1 is shown as a PMOS transistor, a gate of the PMOS transistor is connected to the output end of the comparator U2, a drain thereof is connected to the second pump source D2, and a source thereof is connected to the pump drive module 210. As known from the characteristics of the PMOS transistor, when a source voltage of the PMOS transistor is greater than a gate voltage by a certain value, the PMOS transistor is turned on. Therefore, an appropriate drive voltage value can be set such that the PMOS transistor S1 can be turned on when the comparator U2 outputs a low level (that is, a non-inverting input voltage value of the comparator U2 associated with the operating current of the first pump source D1 is less than the reference voltage Vref), so as to provide a drive current to the second pump source D2. It should be understood that the first transistor S1 may also be an NMOS transistor, a PNP-type triode, or an NPN-type triode; and depending on the specific transistor type, the circuit connection relationship may be adjusted adaptively, and the scope of protection of the disclosure extends to such variants.

Optionally, the pumping system further includes an alarm circuit 240 (not shown) configured to generate a prompt signal when the first pump source D1 is in an abnormal state. By way of example, the drain of the PMOS transistor S1 is connected to an input end of the alarm circuit 240, and when the PMOS transistor S1 is turned on, the alarm circuit 240 and the second pump source D2 are both switched on.

Optionally, the comparison circuit 222 may further include an inverter and a second transistor S2 (not shown). In one example, the second transistor S2 is a PMOS transistor, an input end of the inverter is connected to the output end of the comparator U2, an output end of the inverter is connected to a gate of the second transistor S2, a drain of the second transistor is connected to the first pump source D1, and a source of the second transistor is connected to the pump drive module 230. In this example, when the comparator U2 outputs a low level (that is, the non-inverting input voltage value of the comparator U2 associated with the operating current of the first pump source D1 is less than the reference voltage Vref), the second transistor is turned off, so as to switch off the first pump source D1.

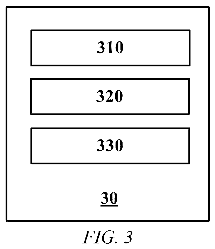

Referring further to FIG. 3 below, FIG. 3 shows a schematic block diagram of a vehicle-mounted laser device 30 according to an embodiment of the disclosure. As shown in FIG. 3, the vehicle-mounted laser device 30 includes a pumping system 310, a seed source 320, and an optical amplifier 330. By way of example, the vehicle-mounted laser device 30 may be a vehicle-mounted laser radar. The pumping system 310 may be the pumping system 10 or the pumping system 20 as shown in FIGS. 1 and 2, and is configured to emit pump light outwards when driven by a current source. The optical amplifier 330 is configured to receive seed light from the seed source 320 and pump light from the pumping system 310, amplify the seed light by stimulated radiation, and then emit a laser beam with the same wavelength outwards. The vehicle-mounted laser device 30 uses a redundant design solution for pump sources and uses pure hardware means to monitor an operating current of the pump source, thus reducing the downtime of the pump source, improving the reliability of the pump source, and supporting automotive-grade certification of the laser radar well.

According to another aspect of the disclosure, there is provided a vehicle, including any one of the pumping systems or vehicle-mounted laser devices as described above.

The embodiments and examples proposed herein are provided to describe as adequately as possible embodiments according to the disclosure and specific applications thereof and thus enable those skilled in the art to implement and use the disclosure. However, those skilled in the art will know that the above descriptions and examples are provided merely for description and illustration. The proposed description is not intended to cover all aspects of the disclosure or limit the disclosure to the disclosed precise forms.

## Claims

1. A pumping system for use in a vehicle-mounted laser, **characterized in that** the pumping system comprises:
a pump source module comprising at least a first pump source and a second pump source, wherein the second pump source serves as a backup pump source for the first pump source; and
a control circuit comprising:
a current measurement circuit configured to measure a real-time operating current of the first pump source; and
a comparison circuit configured to determine an operating state of the first pump source based on the real-time operating current, and to switch on the second pump source when the first pump source is in an abnormal state, so as to provide pump light.

2. The pumping system according to claim 1, **characterized by** further comprising a pump drive module configured to provide a drive current to the pump source module under the control of the control circuit.

3. The pumping system according to claim 1, **characterized in that** the current measurement circuit comprises:
a sampling resistor coupled between a pump drive module and the first pump source; and
a differential amplifier, a non-inverting input end and an inverting input end of the differential amplifier being connected to two ends of the sampling resistor respectively, and an output end of the differential amplifier being connected to the comparison circuit.

4. The pumping system according to claim 1, **characterized in that** the comparison circuit comprises:
a comparator, a non-inverting input end of the comparator being connected to an output end of the current measurement circuit, and an inverting input end of the comparator being connected to a reference voltage; and
a first transistor, the first transistor being turned on when the comparator outputs a low level, so as to provide a drive current to the second pump source.

5. The pumping system according to claim 4, **characterized in that** the first transistor is a PMOS transistor, wherein a gate of the first transistor is connected to an output end of the comparator, a drain of the first transistor is connected to the second pump source, and a source of the first transistor is connected to a pump drive module.

6. The pumping system according to claim 4, **characterized in that** the comparison circuit further comprises a second transistor, the second transistor being turned off when the comparator outputs a low level, so as to switch off the first pump source.

7. The pumping system according to claim 6, **characterized in that** the comparison circuit further comprises an inverter having an input end connected to an output end of the comparator, and the second transistor is a PMOS transistor, wherein a gate of the second transistor is connected to an output end of the inverter, a drain of the second transistor is connected to the first pump source, and a source of the second transistor is connected to a pump drive module.

8. The pumping system according to claim 1, **characterized by** further comprising:
an alarm circuit configured to generate a prompt signal when the first pump source is in an abnormal state.

9. The pumping system according to claim 8, **characterized in that** the alarm circuit has an input end connected to a drain of a first transistor of the comparison circuit, and is activated and generates the prompt signal when the first transistor is turned on.

10. A vehicle-mounted laser device, **characterized by** comprising:
a pumping system according to any one of claims 1 to 9;
a seed source configured to provide seed light; and
an optical amplifier configured to receive the seed light from the seed source and pump light from the pumping system to generate a laser beam.

11. A vehicle, **characterized by** comprising a vehicle-mounted laser device according to claim 10.
